# EUROPÄISCHE PATENTSCHRIFT

(11) **EP 0 944 918 B1**
(45) Veröffentlichungstag und Bekanntmachung des Hinweises auf die Patenterteilung: **18.06.2003**
(21) Anmeldenummer: 97937453.5
(22) Anmeldetag: 13.08.1997
(51) Int. Cl.: H01L 21/306, H01L 21/78, H01L 33/00

(54) **VERFAHREN ZUM HERSTELLEN VON HALBLEITERKÖRPERN MIT MOVPE-SCHICHTENFOLGE**
PROCESS FOR PRODUCING SEMICONDUCTOR BODIES WITH A MOVPE-LAYER SEQUENCE
PROCEDE POUR PRODUIRE DES CORPS SEMI-CONDUCTEURS PRESENTANT UNE SUCCESSION DE COUCHES DEPOSEES PAR EPITAXIE EN PHASE GAZEUSE DE MELANGES ORGANOMETALLIQUES

(30) Priorität: 13.08.1996 DE 19632626
(43) Veröffentlichungstag der Anmeldung: 29.09.1999
(73) Patentinhaber: Osram Opto Semiconductors GmbH & Co. OHG, 93049 Regensburg (DE)
(72) Erfinder: SCHÖNFELD, Olaf, D-93055 Regensburg (DE); NIRSCHL, Ernst, D-93173 Wenzenbach (DE)
(74) Vertreter: Epping, Wilhelm, Dipl.-Ing.
(86) Internationale Anmeldenummer: DE9701738
(87) Internationale Veröffentlichungsnummer: WO98007187

(56) Entgegenhaltungen:
- EP-A- 0 296 419
- DE-A- 4 305 296
- US-A- 4 354 898
- US-A- 5 233 204
- PEARTON S J ET AL: "REACTIVE ION ETCHING OF GAAS, ALGAAS, AND GASB IN CL2 AND SICL4" JOURNAL OF VACUUM SCIENCE AND TECHNOLOGY: PART B, Bd. 8, Nr. 4, 1.Juli 1990, Seiten 607-617, XP000358577
- GROSS M ET AL: "MODELING OF SLOPED SIDEWALLS FORMED BY SIMULTANEOUS ETCHING AND DEPOSITION" JOURNAL OF VACUUM SCIENCE AND TECHNOLOGY: PART B, Bd. 7, Nr. 3, 1.Mai 1989, Seiten 534-541, XP000174588

## Beschreibung

Die Erfindung bezieht sich auf ein Verfahren zum Herstellen von wenigstens einem Halbleiterkörper, bei dem auf einer Substratscheibe mittels metallorganischer Gasphasenepitaxie eine Schichtenfolge mit mindestens einer aktiven Zone aufgebracht wird und bei dem die Schichtenfolge mit wenigstens einem Mesagraben versehen wird. Sie bezieht sich insbesondere auf ein Verfahren zum Herstellen von Lumineszenzdiodenchips mit Mesastruktur mittels MOVPE (Metal Organic Vapor Phase Epitaxy).

Ein Verfahren zum Herstellen von MOVPE-Lumineszenzdiodenchips ist beispielsweise aus der US-Patentschrift 5,233,204 bekannt. Hierbei wird auf einer GaAs-Substratscheibe mittels metallorganischer Dampfphasenepitaxie (MOVPE) eine Heterostruktur aus einer n-leitenden ersten InGaAlP-Begrenzungsschicht, einer n-leitenden aktiven InGaAlP-Schicht und einer p-leitenden zweiten InGaAlP-Begrenzungsschicht abgeschieden. Auf die zweite InGaAlP-Begrenzungsschicht wird eine Fensterschicht aus AlGaAs, GaAsP oder GaP mittels Epitaxie aufgebracht. Anschließend wird auf die Unterseite der Substratscheibe eine Unterseitenkontaktmetallisierung und auf die Oberseite der Fensterschicht eine Mehrzahl von Oberseitenkontaktmetallisierungen aufgebracht. Der nach diesem Verfahren hergestellte Halbleiterwafer wird nachfolgend mittels Sägen oder Trennschleifen in einzelne Leuchtdiodenchips vereinzelt.

Die Fensterschicht dient bei den Leuchtdiodenchips erstens dazu, eine laterale Stromausbreitung möglichst über den gesamten Querschnitt des pn-Überganges zu erzielen und zweitens, die zur Lichtauskoppelung zur Verfügung stehende Oberfläche der Leuchtdiodenchips zu vergrößern. Das Verhältnis der vom Oberseitenkontakt abgedeckten Fläche des Halbleiterkörpers zur freien Oberfläche des Halbleiterkörpers wird vergrößert. Es geht jedoch nach wie vor ein großer Teil der in der aktiven Zone erzeugten Strahlung durch Totalreflexion an der Oberfläche der Leuchtdiodenchips verloren.

Darüberhinaus entstehen beim Sägen oder Trennschleifen des Halbleiterwafers Zerstörungen an den Seitenflächen der Epitaxieschichten, die unter anderem eine beschleunigte Alterung (Degradation der Helligkeit der LED über der Zeit) der LED-Chips verursachen.

Aus der DE 43 05 296 A1 ist ein Verfahren zum Herstellen einer Lumineszenzdiode bekannt, bei dem in einer auf einem Substratkörper epitaktisch aufgebrachten Schichtenfolge zur Verbesserung der Strahlungsleistung mittels naßchemischem Ätzen Mesagräben ausgebildet werden.

Ein derartiges naßchemisches Ätzverfahren führt bei mittels MOVPE hergestellten Lumineszenzdiodenchips jedoch zu einer selektiven Ätzung der MOVPE-Schichtenfolge. Dadurch entstehen sogenannte "Pilz"-Strukturen, die bei mit einer Kunststoffumhüllung versehenen Halbleiterchips infolge mechanischer Beanspruchung wiederum eine beschleunigte Alterung (Degradation der elektrischen Eigenschaften über die Zeit) hervorrufen.

In der US 5,309,001 ist ein MOVPE- Leuchtdiodenchip mit Mesastruktur beschrieben, die mittels naßchemischem Ätzen oder mittels reaktivem Ionenstrahlätzen hergestellt wird. Der externe Quantenwirkungsgrad derartiger Dioden ist aber immer noch sehr niedrig.

In S.J. Pearton et al., J. Vac. Sci. Technol, B8(4), Jul/Aug. 1990, 607-617, ist eine Versuchsreihe zum Trochenätzen von GaAs, AlG-As and GaSb in Cl₂ und SiCl₄ beschrieben, um die Abhängigkeit der Ätzsorte von verschiedenen Atzparametern zu ermitteln.

In der US 4, 354, 898 ist ein Ätzverfahren zum Herstellen von optisch glatten Spiegelfarcetten in I Ga Asl/InP-Heterostrukturen beschrieben, bei dem ein Trockenätzverfahren eingesetzt werden kann, um einen Graben zu erzeugen.

In der EP 0 296 419 A2 ist ein Trockenätzverfahren zu Herstellen von Trenngraben in integrierten Schaltkreisen beschrieben.

Die Aufgabe der Erfindung besteht darin, ein Verfahren der eingangs genannten Art zu entwickeln, mit dem Halbleiterkörper hergestellt werden können, die eine verringerte Alterung aufweisen. Sie besteht weiterhin insbesondere darin, ein Verfahren zur Verfügung zu stellen, mit dem MOVPE-Lumineszenzdiodenchips mit einer verbesserten Auskopplung der in der aktiven Schicht erzeugten Strahlung aus dem Halbleiterkörper hergestellt werden können.

Diese Aufgabe wird durch ein Verfahren mit den Merkmalen des Anspruches 1 gelöst. Vorteilhafte Weiterbildungen des erfindungsgemäßen Verfahrens sind Gegenstand der Unteransprüche 2 bis 11.

Erfindungsgemäß ist vorgesehen, daß auf einer Substratscheibe mittels metallorganischer Gasphasenepitaxie (MOVPE) eine Schichtenfolge mit mindestens einer aktiven Zone aufgebracht wird. Die aktive Zone ist beispielsweise bei einem Lumineszenzdioden- oder Photodiodenchip derart ausgebildet, daß sie Licht aussendet, wenn sie mit einem elektrischen Strom beaufschlagt ist und/oder daß sie eine elektrische Spannung erzeugt, falls sie Licht empfängt. Die Schichtenfolge wird mittels Trockenätzen mit wenigstens einem Mesagraben versehen, wobei während des Trockenätzens die Ätzparameter derart verändert werden, daß mit zunehmender Ätztiefe das Verhältnis von vertikaler Ätzrate zu horizontaler Ätzrate erhöht wird, so daß ein Halbleiterkörper mit mindestens einer von außerhalb des Halbleiterkörpers gesehen konkav gekrümmten Seitenfläche erzeugt wird.

Dabei wird während des Trockenätzens zum Erhöhen des Verhältnisses von vertikaler Ätzrate zu horizontaler Ätzrate bevorzugt die Konzentrationen der verschiedenen Gase eines Ätzgas-Gemisches variiert.

Zum Ätzen des Mesagrabens in einem Halbleiterkörper, der im Wesentlichen GaAs, GaP oder GaN oder mindestens eines Legierung dieser Verbindungshalbleiter mit A1 und/oder In aufweist, wird bevorzugt ein Ätzgas-Gemisch verwendet, das mindestens Chlor und Siliziumtetrachlorid oder mindestens Chlor und Bortrichlorid aufweist. Im Vergleich zu herkömmlichen Ätzgas-Gemischen, die nur ein einziges der Gase Siliziumtetrachlorid, Bortrichlorid und Chlor enthalten, wird durch die Zugabe von Chlor und mindestens eine der Komponenten Siliziumtetrachlorid und Bortrichlorid eine deutlich erhöhte Ätzrate erreicht. Durch Änderung der Chlorkonzentration im Ätzgas-Gemisch ist eine insitu-Variation der Ätzrate und damit die Einstellung beliebiger Ätzwinkel möglich. Wird die Chlor-Konzentration im Ätzgas-Gemisch erfindungsgemäß mit zunehmender Ätztiefe verringert, so entsteht ein Mesgraben mit einer konkav gekrümmten Innenfläche.

Bevorzugt wird der Mesagraben so tief in die MOVPE-Schichtenfolge hineingeätzt, daß die aktive Zone durchtrennt ist. Nachfolgend wird der Verbund zu einzelnen Halbleiterkörpern mit wenigstens einer Mesaflanke vereinzelt.

Beim Trockenätzen tritt keine selektive Ätzung der MOVPE-Schichtenfolge auf. Dadurch entstehen keine "Pilz"-Strukturen, die eine erhöhte mechanische Beanspruchung und folglich eine beschleunigte Alterung des Halbleiterkörpers hervorrufen würden.

Weiterhin weisen bei einem nach dem erfindungsgemäßen Verfahren hergestellten Halbleiterkörper die Seitenflächen der aktiven Zone, beispielsweise ein Licht aussendender und/oder empfangender pn-Übergang, vorteilhafterweise deutlich geringere Zerstörungen auf als dies bei mittels Sägen oder Trennschleifen hergestellten Halbleiterkörpern der Fall ist.

Ein weiterer Vorteil des erfindungsgemäßen Verfahrens besteht darin, daß im Falle von Licht aussendenen Halbleiterkörpern durch die Krümmung der Seitenflächen (Mesakrümmung) des Halbleiterkörpers im Vergleich zu den herkömmlich hergestellten Halbleiterkörpern mit ebenen Seitenflächen ein größerer Anteil des in der aktiven Zone erzeugten Lichtes in einem Winkel auf die Grenze zwischen dem Halbleiterkörper und dem umgebenden Medium (z. B. Luft oder Kunststoff) fällt, der kleiner als der Grenzwinkel der Totalreflexion ist. Daher wird weniger Licht in den Halbleiterkörper zurückreflektiert; der optische Wirkungsgrad ist erhöht.

Besonders vorteilhaft ist weiterhin, daß mittels dem erfindungsgemäßen Verfahren beim Mesaätzen bereits voneinander getrennte Bereiche der aktiven Zone erzeugt werden, die untereinander mittels der nicht durchgeätzten Substratscheibe mechanisch verbunden sind. Dadurch ist es möglich, eine Funktionsmessung der voneinander getrennten aktiven Zonen im Scheibenverbund vorzunehmen und erst nachfolgend die Substratscheibe, z. B. mittels Sägen, endgültig zu voneinander getrennten Halbleiterkörpern zu vereinzeln.

Es kann z. B. somit vorteilhafterweise eine 100%-Messung von durchätzten pn-Übergängen im Waferverbund mit Waferprobern durchgeführt werden.

Bei einer bevorzugten Ausführungsform des erfindungsgemäßen Verfahrens besteht die Substratscheibe im wesentlichen aus GaAs.

Besonders vorteilhaft läßt sich das erfindungsgemäße Verfahren bei Halbleiterkörpern anwenden, die eine Schichtenfolge mit einer oder mehreren Halbleiterschichten aus InGaAlP aufweisen. Derartige Halbleiterschichten besitzen nämlich nach einem herkömmlichen Durchtrennen des Verbundes mittels Sägen starke Zerstörungen an ihren Seitenflanken. Bei einer bevorzugten Ausführungsform weist die Schichtenfolge eine n-leitende erste InGaAlP-Begrenzungsschicht, eine n-leitende aktive InGaAlP-Schicht und eine n-leitende zweite InGaAlP-Begrenzungsschicht auf.

Bei einer bevorzugten Verwendung des erfindungsgemäßen Verfahrens zum Herstellen von Licht aussendenden und/oder Licht empfangenden Halbleiterkörpern wird vorteilhafterweise auf der Schichtenfolge eine beispielsweise aus einem Halbleitermaterial bestehende Fensterschicht hergestellt, die für das von der aktiven Zone ausgesandte und/oder empfangene Licht durchlässig ist.

Bei einer besonders bevorzugten Weiterbildung dieser Ausführungsform wird die Fensterschicht aus einem Material hergestellt, das eine größere elektrische Leitfähigkeit als die Schichtenfolge aufweist.

Die Dicke der Fensterschicht kann im Vergleich zu der Fensterschicht des eingangs beschriebenen bereits bekannten Halbleiterkörpers vorteilhafterweise deutlich reduziert werden und beispielsweise zwischen 10 und 60 µm liegen. Aufgrund der Mesakrümmung der Seitenflächen des nach unserer Erfindung hergestellten Halbleiterkörpers fällt nämlich ein größerer Anteil des in der aktiven Zone erzeugten Lichtes in einem Winkel auf die Grenze zwischen dem Halbleiterkörper und dem umgebenden Medium (z. B. Luft oder Kunststoff), der kleiner als der Grenzwinkel der Totalreflexion ist.

Bei einer bevorzugten Ausführungsform des erfindungsgemäßen Verfahrens wird auf die Schichtenfolge eine Fensterschicht aus GaP oder AlGaAs aufgebracht.

Bei einer weiteren bevorzugten Ausführungsform des erfindungsgemäßen Verfahrens wird beim Trockenätzen eine Aufrauhung der Seitenflächen der Halbleiterkörper erzeugt. Dies bewirkt bei Licht aussendenden Halbleiterkörpern vorteilhafterweise eine Verbesserung der Lichtauskoppelung, weil dadurch wiederum der Anteil der von der aktiven Zone ausgesandten Strahlung, der unter einem Winkel auf die Grenze zwischen dem Halbleiterkörper und dem umgebenen Medium fällt, der kleiner als der Grenzwinkel der Totalreflexion ist, vergrößert wird.

Bei einer besonders bevorzugten Weiterbildung des erfindungsgemäßen Verfahrens, wird die Anordnung der Mesagräben so gewählt, daß alle Seitenflächen der Halbleiterkörper eine Mesakrümmung aufweisen.

Außerdem wird bei Halbleiterkörpern, die mit einer Kunststoffumhüllung versehen sind, durch die Aufrauhung eine verbesserte Haftung zwischen Kunststoffumhüllung und Halbleiterkörper erzielt. Dadurch wird die Gefahr einer Delamination zwischen Halbleiterkörper und Kunststoffumhüllung verringert werden.

Mit dem erfindungsgemäßen Verfahren können vorteilhafterweise Licht aussendende und/oder empfangende Halbleiterkörper hergestellt werden, deren optischer Wirkungsgrad bei etwa 70 % liegt.

Weiterhin ist denkbar, daß das erfindungsgemäße Verfahren nicht nur bei Halbleiterwafern mit MOVPE-Schichtenfolge angewendet wird sondern auch für Halbleiterwafer einsetzbar ist, die gemäß irgendeinem anderen Abscheidungsverfahren (z. B. Flüssigphasenepitaxie, CVD oder MBE usw.) hergestellt sind.

Bei einer Schichtenfolge mit einer n-leitenden ersten InGaAlP-Begrenzungsschicht, einer n-leitenden aktiven InGaAlP-Schicht und einer n-leitenden zweiten InGaAlP-Begrenzungsschicht weist das Ätzgas-Gemisch bevorzugt Cl₂ und BCl₃ oder Cl₂ und SiCl₄ auf. Zum Erhöhen des Verhältnisses von vertikaler Ätzrate zu horizontaler Ätzrate wird hierbei während des Ätzens des Mesagrabens die Konzentration von Cl₂ im Ätzgas-Gemisch verändert.

Die Erfindung wird im folgenden anhand von drei Ausführungsbeispielen in Verbindung mit den Figuren 1 bis 4 näher erläutert. Es zeigen:
Figur 1 eine schematische Darstellung des Ablaufes eines ersten Ausführungsbeispieles des erfindungsgemäßen Verfahrens,
Figur 2 eine schematische Darstellung eines nach einem zweiten Ausführungsbeispiel des erfindungsgemäßen Verfahrens hergestellten Halbleiterkörpers,
Figur 3 eine schematische Darstellung eines nach einem dritten Ausführungsbeispiel des erfindungsgemäßen Verfahrens hergestellten Halbleiterkörpers und
Figur 4 eine schematische Darstellung einer Draufsicht auf einen Ausschnitt einer nach dem erfindungsgemäßen Verfahren hergestellten Halbleiterscheibe.

In den verschiedenen Figuren sind gleichartige Komponenten jeweils mit demselben Bezugszeichen versehen.

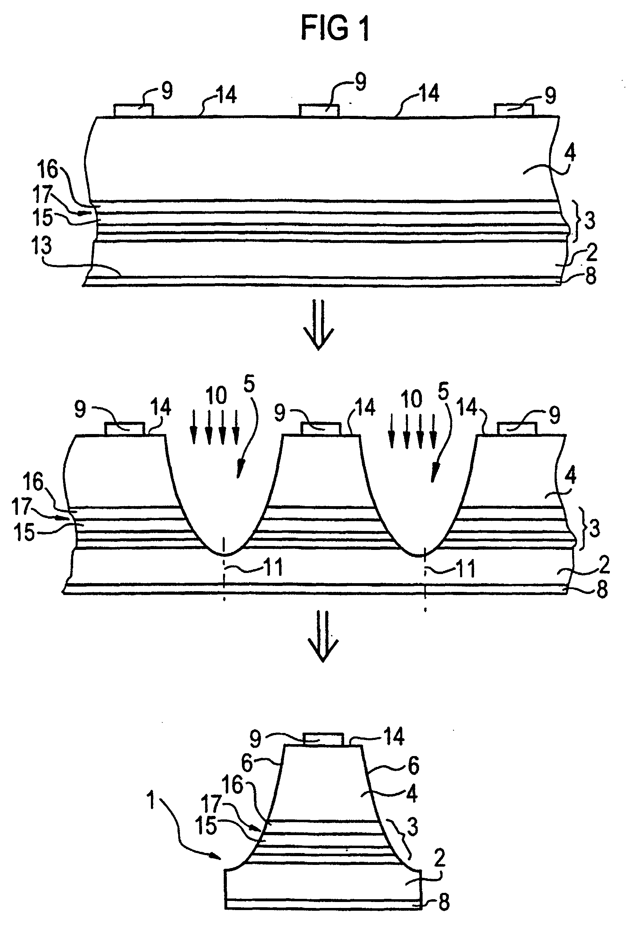

Bei dem Verfahren gemäß Figur 1 wird zunächst auf einer Substratscheibe 2, die beispielsweise aus GaAs besteht, mittels metallorganischer Gasphasenepitaxie (MOVPE) eine Schichtenfolge 3 aufgebracht. Diese Schichtenfolge besteht beispielsweise aus InGaAsP und weist eine aktive Zone 17 auf. Die aktive Zone 17 ist beispielsweise ein pn-Übergang einer Leuchtdiode. Die Schichtenfolge 3 weist hierbei z. B. eine n-leitende 15 und eine p-leitende InGaAlP-Epitaxieschicht 16 auf.

Die aktive Zone 17 wird derart ausgebildet, daß sie Licht aussendet, falls sie mit einem elektrischen Strom beaufschlagt ist und/oder daß sie eine elektrische Spannung erzeugt, falls sie Licht empfängt. Derartige aktive Zonen und die zugehörigen Herstellverfahren sind dem Fachmann geläufig und werden daher hier nicht mehr näher beschrieben.

Auf die Schichtenfolge 3 wird nachfolgend z. B. mittels metallorganischer Gasphasenepitaxie (MOVPE) oder Flüssigphasenepitaxie (LPE) eine Fensterschicht 4 aufgebracht, die beispielsweise aus GaP oder AlGaAs besteht. Dieses Halbleitermaterial besitzt einen größeren Bandabstand als InGaAlP und ist deshalb für das von der aktiven Zone ausgesandte und/oder empfangene Licht durchlässig.

Im Anschluß daran wird auf die Unterseite 13 der Substratscheibe 2 eine erste Kontaktmetallisierung 8 und auf die Oberseite 14 der Fensterschicht 4 eine Mehrzahl von zweiten Kontaktmetallisierungen 9 aufgebracht. Diese bestehen beispielsweise aus herkömmlichen in der Halbleitertechnik verwendeten metallischen Kontaktwerkstoffen.

Als nächster Schritt werden ggf. nach einem Aufbringen einer beispielsweise aus Metall, Oxid oder organischem Lack bestehenden Mesamaske auf die Oberseite 14 der Fensterschicht 4 und die zweiten Kontaktmetallisierungen 9 in den Verbund aus Substratscheibe 2, Schichtenfolge 3, Fensterschicht 4 und den ersten und zweiten Kontaktmetallisierungen 8, 9 mittels Trokkenätzen (angedeutet durch die Pfeile 10) eine Mehrzahl von Mesagräben 5 mit gekrümmten Mesaflanken 6 geätzt.

Während des Trockenätzens 10 werden die Ätzparameter derart verändert, daß mit zunehmender Ätztiefe das Verhältnis von vertikaler Ätzrate zu horizontaler Ätzrate erhöht wird. Dadurch enstehen die gekrümmten Mesaflanken. Die Tiefe dieser Mesagräben 5 wird so gewählt, daß die Fensterschicht 4 und die Schichtenfolge 3 vollständig durchtrennt werden und die Substratscheibe 2 nur angeätzt wird.

Als Trockenätzverfahren kann beispielsweise Reaktives Ionenätzen (RIE für Reactive Ion Etching), Plasmaätzen oder ein anderes dem Fachmann als geeignet bekanntes Trockenätzverfahren eingesetzt werden.

Als Ätzgas-Gemisch für RIE wird beispielsweise CH₄/Ar/H₂/Cl₂/BCl₃ oder CH₄/Ar/H₂/Cl₂/SiCl₄ verwendet. Zum Erhöhen des Verhältnisses von vertikaler Ätzrate zu horizontaler Ätzrate wird hierbei während des Ätzens 10 die Konzentration von Cl₂ im Ätzgas-Gemisch verändert.

Nachfolgend wird die Substratscheibe 2 und die erste Kontaktmetallisierung 8 in den Mesagräben 5 entlang der durch die strichpunktierten Linien 11 angedeuteten Trennlinien beispielsweise mittels Trennschleifen zu einzelnen lichtaussendenden und/oder lichtempfangenden Halbleiterkörpern 1 mit Mesaflanken 6 vereinzelt.

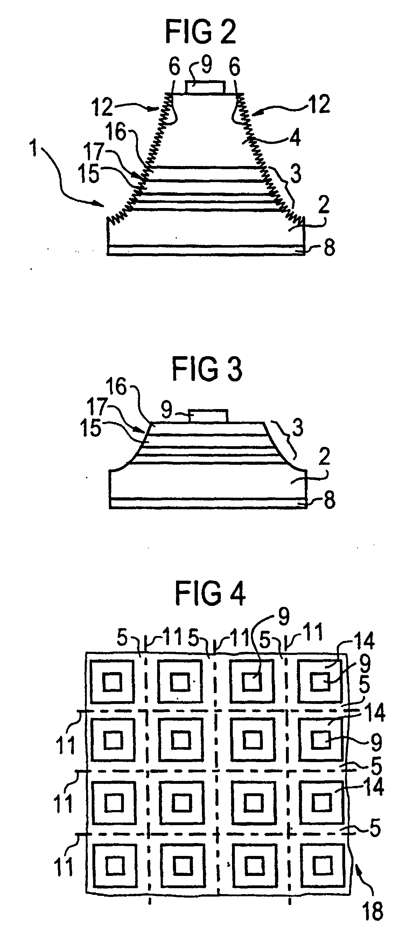

Die Anordnung der Mesagräben 5 kann beispielsweise derart gewählt sein, daß die Halbleiterkörper 1, wie in Figur 4 dargestellt, jeweils auf allen vier Seitenflächen eine Mesakrümmung aufweisen. Die Mesagräben werden dazu beispielsweise in einem Viereckraster 18 angeordnet. Die Halbleiterscheibe wird nach dem Ätzen der Mesagräben 5 in diesen entlang der Trennlinien 11 durchtrennt und somit zu einer Mehrzahl von Halbleiterkörpern 1 mit Mesaflanken 6 vereinzelt.

Mit dem oben beschriebenen Verfahren werden Halbleiterkörper 1 hergestellt, die mindestens eine von außerhalb des Halbleiterkörpers 1 gesehen konkave Seitenfläche 6 aufweisen.

Der Halbleiterkörper 1 von Figur 2 unterscheidet sich von den Halbleiterkörpern nach Figur 1 dadurch, daß er Mesaflanken 6 auf weist, die eine Aufrauhung 12 besitzen. Diese Aufrauhung 12 kann beispielsweise durch eine geeignete Einstellung der Trockenätzparameter beim Ätzen der Mesagräben 5 erzeugt werden. Die Tiefe der Aufrauhung 12 kann beispielsweise zwischen 50 und 300 µm liegen. Außer diesem gibt es keinen Unterschied zwischen dem Verfahren zum Herstellen einer Mehrzahl derartiger Halbleiterkörper und dem in Verbindung mit Figur 1 beschriebenen Verfahren.

Weiterhin kann das oben beschriebene Verfahren natürlich ebenso zur Herstellung von Halbleiterkörpern 1 angewendet werden, die keine Fensterschicht 4 aufweisen. Bei derartigen Halbleiterkörpern 1 werden dann beispielsweise, wie in Figur 3 gezeigt, die zweiten Kontaktmetallisierungen 9 direkt auf die Schichtenfolge 3 aufgebracht. Das weitere Verfahren läuft analog zu den oben beschriebenen Verfahren ab.

## Patentansprüche

1. Verfahren zum Herstellen von wenigstens einem Halbleiterkörper (1), bei dem auf einer Substratscheibe (2) mittels metallorganischer Gasphasenepitaxie eine Schichtenfolge (3) mit mindestens einer aktiven Zone (17) aufgebracht wird und bei dem die Schichtenfolge (3) mit wenigstens einem Mesagraben (5) versehen wird, **dadurch gekennzeichnet, daß** der Mesagraben mittels Trockenätzen (10) hergestellt wird, wobei während des Trockenätzens (10) die Ätzparameter derart verändert werden, daß mit zunehmender Ätztiefe das Verhältnis von vertikaler Ätzrate zu horizontaler Ätzrate erhöht wird, wobei der Halbleiterkörper (1) im Wesentlichen GaAs, GaP oder GaN oder mindestens eine Legierung dieser Verbindungshalbleiter mit A1 und/oder In aufweist, ein Ätzgas-Gemisch verwendet wird, das mindestens Chlor und Siliziumtetrachlorid oder mindestens Chlor und Bortrichlorid aufweist, und die Chlorkonzentration im Ätzgas-Gemisch während des Ätzens (10) verringert wird.

2. Verfahren nach Anspruch 1, **dadurch gekennzeichnet, daß** während des Trockenätzens (10) zum Erhöhen des Verhältnisses von vertikaler Ätzrate zu horizontaler Ätzrate die Konzentrationen der verschiedenen Gase eines Ätzgas-Gemisches variiert werden.

3. Verfahren nach einem der Ansprüche 1 und 2, **dadurch gekennzeichnet, daß** beim Trockenätzen (10) die aktive Zone (17) der Schichtenfolge (3) durchtrennt wird und daß nachfolgend der Verbund aus Substratscheibe (2) und Schichtenfolge (3) derart durchtrennt wird, daß wenigstens ein Halbleiterkörper (1) mit mindestens einer Mesaflanke (6) erzeugt wird.

4. Verfahren nach einem der Ansprüche 1 bis 3, **dadurch gekennzeichnet, daß** der Halbleiterkörper (1) ein Licht aussendender und/oder Licht empfangender Halbleiterkörper mit einer Licht aussendenden und/oder Licht empfangenden aktiven Zone (17) ist.

5. Verfahren nach Anspruch 4, **dadurch gekennzeichnet, daß** vor dem Trockenätzen auf der Schichtenfolge (3) eine Fensterschicht (4) hergestellt wird, die für das ausgesandte und/oder empfangene Licht durchlässig ist.

6. Verfahren nach einem der Ansprüche 1 bis 5 **dadurch gekennzeichnet, daß** die Substratscheibe (2) im wesentlichen aus GaAs besteht.

7. Verfahren nach einem der Ansprüche 1 bis 6, **dadurch gekennzeichnet, daß** die Schichtenfolge (3) mindestens eine Halbleiterschicht aus InGaAlP aufweist.

8. Verfahren nach Anspruch 7, **dadurch gekennzeichnet, daß** als Schichtenfolge (3) eine n-leitende erste InGaAlP-Begrenzungsschicht (15), anschließend eine n-leitende aktive InGaAlP-Schicht (16) und nachfolgend eine n-leitende zweite InGaAlP-Begrenzungsschicht (17) aufgebracht wird.

9. Verfahren nach Anspruch 5 oder nach Anspruch 5 und einem der Ansprüche 6 bis 8, **dadurch gekennzeichnet, daß** die Fensterschicht (4) im wesentlichen aus GaP oder AlGaAs hergestellt wird.

10. Verfahren nach einem der Ansprüche 1 bis 9, **dadurch gekennzeichnet, daß** beim Trockenätzen eine Aufrauhung (12) der Mesaflanken (6) erzeugt wird.

11. Verfahren nach einem der Ansprüche 1 bis 10, **dadurch gekennzeichnet, daß** die Mesagräben (5) derart angeordnet werden, daß der Halbleiterkörper (1) auf allen Seitenflächen eine Mesaflanke (6) aufweist.

## Claims

1. Process for producing at least one semiconductor body (1), in which a layer sequence (3) with at least one active zone (17) is applied on a substrate wafer (2) by means of metal organic vapour phase epitaxy, and in which the layer sequence (3) is provided with at least one mesa trench (5), **characterized in that** the mesa trench is produced by means of dry etching (10), the etching parameters being altered during the dry etching (10) in such a way that the ratio of vertical etching rate to horizontal etching rate is increased as the etching depth increases, the semiconductor body (1) essentially comprising GaAs, GaP or GaN or at least one alloy of these compound semiconductors with Al and/or In, an etching gas mixture being used which comprises at least chlorine and silicon tetrachloride or at least chlorine and boron trichloride, and the chlorine concentration in the etching gas mixture being reduced during the etching (10).

2. Process according to Claim 1, **characterized in that** the concentrations of the different gases of an etching gas mixture are varied during the dry etching (10) in order to increase the ratio of vertical etching rate to horizontal etching rate.

3. Process according to either of Claims 1 and 2, **characterized in that** the active zone (17) of the layer sequence (3) is severed during the dry etching (10), and **in that** the composite comprising substrate wafer (2) and layer sequence (3) is subsequently severed in such a way as to produce at least one semiconductor body (1) with at least one mesa sidewall (6).

4. Process according to one of Claims 1 to 3, **characterized in that** the semiconductor body (1) is a light-emitting and/or light-receiving semiconductor body with a light-emitting and/or light-receiving active zone (17).

5. Process according to Claim 4, **characterized in that** a window layer (4) is produced before the dry etching on the layer sequence (3), which window layer is transmissive for the emitted and/or received light.

6. Process according to one of Claims 1 to 5, **characterized in that** the substrate wafer (2) essentially comprises GaAs.

7. Process according to one of Claims 1 to 6, **characterized in that** the layer sequence (3) comprises at least one semiconductor layer made of InGaAlP.

8. Process according to Claim 7, **characterized in that** an n-conducting first InGaAlP boundary layer (15), then an n-conducting active InGaAlP layer (16) and afterwards an n-conducting second InGaAlP boundary layer (17) are applied as the layer sequence (3).

9. Process according to Claim 5 or according to Claim 5 and one of Claims 6 to 8, **characterized in that** the window layer (4) is essentially produced from GaP or AlGaAs.

10. Process according to one of Claims 1 to 9, **characterized in that** a roughness (12) of the mesa sidewalls (6) is produced during the dry etching.

11. Process according to one of Claims 1 to 10, **characterized in that** the mesa trenches (5) are arranged in such a way that the semiconductor body (1) comprises a mesa sidewall (6) on all side areas.

## Revendications

1. Procédé de production d'au moins un corps (1) semi-conducteur, dans lequel on dépose sur une tranche (2) servant de substrat au moyen d'une épitaxie métallo-organique en phase gazeuse une succession (3) de couches ayant au moins une zone (17) active et dans lequel on munit la succession (3) de couches d'au moins un sillon (5) mésa, **caractérisé en ce que** l'on produit le sillon mésa au moyen d'une attaque (10) à sec, dans lequel on modifie pendant l'attaque (10) à sec les paramètres d'attaque de façon que le rapport de la vitesse verticale d'attaque sur la vitesse horizontale d'attaque augmente à mesure que la profondeur de l'attaque augmente, dans lequel le corps (1) semi-conducteur comprend essentiellement du GaAs, du GaP, du GaN ou au moins un alliage de ces semi-conducteurs composés avec du Al et /ou du In, on utilise un mélange d'attaque gazeux qui comprend au moins du chlore et du tétrachlorure de silicium ou au moins du chlore et du trichlorure de bore et on diminue la concentration de chlore dans le mélange d'attaque gazeux pendant l'attaque (10).

2. Procédé suivant la revendication 1, **caractérisé en ce que**, pendant l'attaque (10) à sec, pour augmenter le rapport de la vitesse verticale d'attaque à la vitesse horizontale d'attaque, on fait varier les concentrations des divers gaz d'un mélange d'attaque gazeux.

3. Procédé suivant l'une des revendications 1 et 2, **caractérisé en ce que**, lors de l'attaque (10) à sec, on sépare la zone (17) active de la succession (3) de couches et **en ce que** ensuite on sépare le composite constitué de la tranche (2) servant de substrat et de la succession (3) de couches de manière à produire au moins un corps (1) semi-conducteur ayant au moins un flanc (6) mésa.

4. Procédé suivant l'une des revendications 1 à 3, **caractérisé en ce que** le corps (1) semi-conducteur est un corps semi-conducteur émettant de la lumière et / ou recevant de la lumière ayant une zone (17) active émettant la lumière et / ou recevant de la lumière.

5. Procédé suivant la revendication 4, **caractérisé en ce que**, avant l'attaque à sec, on ménage sur la succession (3) des couches une couche (4) de fenêtre qui est transparente à la lumière émise et / ou reçue.

6. Procédé suivant l'une des revendications 1 à 5, **caractérisé en ce que** la tranche (2) servant de substrat est essentiellement en GaAs.

7. Procédé suivant l'une des revendications 1 à 6, **caractérisé en ce que** la succession (3) de couches comprend au moins une couche semiconductrice en InGaAlP.

8. Procédé suivant la revendication 7, **caractérisé en ce que** l'on dépose comme succession (3) de couches une première couche (15) de délimitation de conductivité n en InGaAlP, ensuite une couche (16) active de conductivité n en InGaAlP et ensuite une deuxième couche (17) de délimitation de conductivité n en InGaAlP.

9. Procédé suivant la revendication 5, et l'une des revendications 6 à 8, **caractérisé en ce que** l'on produit la couche (4) de fenêtre essentiellement en GaP ou en AlGaAs.

10. Procédé suivant l'une des revendications 1 à 9, **caractérisé en ce que**, lors de l'attaque à sec, on rend les flancs (6) mésa rugueux (12).

11. Procédé suivant l'une des revendications 1 à 10, **caractérisé en ce que** l'on dispose les sillons (5) mésa de façon à ce que le corps (1) semi-conducteur ait un flanc (6) mésa sur toutes les faces latérales.
